# EUROPEAN PATENT APPLICATION

(11) **EP 4 170 361 A1**
(43) Date of publication of application: **26.04.2023**
(21) Application number: 21306477.7
(22) Date of filing: 22.10.2021
(51) Int. Cl.: G01R 29/08, G09B 23/30, H04B 17/00, H04M 1/24

(54) **DEVICE FOR ELECTROMAGNETIC DOSIMETRY COMPRISING AN INTEGRATING ELEMENT**

(71) Applicant: Université de Rennes 1, 35000 Rennes (FR); CENTRE NATIONAL DE LA RECHERCHE SCIENTIFIQUE (CNRS), 75016 Paris (FR); Institut National des Sciences Appliquées de Rennes, 35708 Rennes Cedex 7 (FR); Universite de Nantes, 44000 Nantes (FR); Centrale Supélec, 91190 Gif-sur-Yvette (FR)
(72) Inventor: ZHADOBOV, Maxim, 35700 RENNES (FR); BORYSKIN, Artem, 35235 THORIGNE FOUILLARD (FR); SAULEAU, Ronan, 35690 ACIGNE (FR)
(74) Representative: Plasseraud IP

(57) **Abstract**

A device (1) for measuring a physical quantity related to an electromagnetic (EM) field emitted by an electromagnetic source (2), the device configured to simulate at least one EM scattering characteristic of a reference object made of an EM lossy medium, in particular a biological tissue, comprising:
- at least one dielectric layer (3) comprising a top surface (31) oriented to the electromagnetic source (2) and a bottom surface (32), said layer (3) being at least partly transparent to the EM field emitted by the electromagnetic source (2);
- at least one aperture focusing element (4) attached to or at least partly embedded in the bottom surface (32) of the dielectric layer (3), said at least one aperture focusing element (4) configured to focus the EM field incident on the at least one aperture element (4) into a focal zone (9);
- at least one sensor (5) arranged beneath the at least one aperture focusing element (4) and configured to measure the physical quantity related to the electromagnetic field transmitted through the at least one dielectric layer (3) and the aperture focusing element (4), said at least one sensor (5) being positioned in the focal zone (9).

## Description

### Field of the invention

The invention relates to a device for electromagnetic dosimetry, and more particularly, the present invention relates to a device for simulating some electromagnetic characteristics of a reference object made of a lossy medium, e.g. a biological tissue, particularly a human tissue, and determining the electromagnetic dosimetry quantities induced in the lossy medium by electromagnetic fields emitted by an electromagnetic source.

### Background Art

With the development of the wireless technology, in particularly in case of cell phones which are used in proximity with the human body, determining precisely the electromagnetic exposure level in a human body becomes a critical factor.

Various categories of devices reproducing electromagnetic properties of biological tissues, commonly referred as "phantoms", for evaluating the exposure of the human body to electromagnetic waves exist: liquid phantoms, semi-solid phantoms, solid phantoms as well as hybrid phantoms. The liquid phantoms comprise a plastic part or a solid shell filled with a gel or a liquid having similar generic electromagnetic properties to those of the human biological tissues at the measurement frequency. Such devices are generally used in the frequency range from 300 MHz to 6 GHz. These devices have several problems: the liquid needs to be changed frequently due to the evaporation and/or the degradation of the electromagnetic properties of the liquid over time. These devices require special test equipment to support their weight. Composition of the semi-solid phantoms is similar to the liquid phantom and a jellifying agent is usually used instead of a liquid to retain the shape of the phantom without using a solid shell. Their main drawback is a limited lifetime (typically limited to days or weeks). The solid phantom is a solid piece made of ceramic, graphite or carbon elements, or synthetic rubbers. The main advantage is the reliability and the constancy of the electromagnetic properties thereof over time. However, these devices are quite complex to fabricate and costly to manufacture, generally requiring particularly high temperatures and high pressures. Furthermore, the solid phantoms, same as the other types of the phantoms designed to operate at frequencies below 6 GHz, cannot be used at higher frequencies due to the frequency dispersive properties of the materials. For instance, at 60 GHz, the penetration depth of electromagnetic radiation in the human tissues is of the order of 0.5 mm and the absorption of radiation is essentially limited to the superficial layers of the body. This leads to a prohibitively low signal-to-noise ratio (SNR) for any sensor embedded in a phantom reproducing the EM properties of said biological tissue.

In addition, recent wireless communication devices often have more than one antenna and are able to operate in multiple frequency bands and modes. The use of traditional EM dosimetry devices has several limitations and drawbacks, among which is the complex and time-consuming compliance testing procedure.

In this perspective, due to the specificity of the frequency-dependent interaction between the human body and the wireless devices, leading to lower reflection and simultaneously to stronger EM losses, and the compliance testing of wireless devices of 5G and beyond generations operating at frequencies above 6 GHz, the new dosimetry standards and guidelines are formulated in terms of the transmitted and/or absorbed electromagnetic power density per a given surface area, which is proportional to the EM field intensity, instead of the measurement of the volumetric dosimetric quantities, such as specific absorption rate (SAR).

The document WO2017/0173350 and with reference to figure 1, proposes a device having characteristic of human tissues while being able to measure electromagnetic fields at frequencies greater than 6 GHz. It comprises one layer of a dielectric material (S), a semitransparent metal shield (MSH) with through holes (OSH) and an array of sensors (SENS) placed below the through holes. The sensors are configured to measure the electromagnetic field emitted by an electromagnetic source (EMS).

Although the device proposed in this document offers the reliability and the constancy of the electromagnetic properties and potentially allows a measurement of electromagnetic fields at frequencies above 6 GHz, the proposed solution does not teach how to reduce or limit the significant losses of the electromagnetic field intensity during its propagation through the compound dielectric material comprising a high quantity of carbon microparticles (with volume ratio of about 40%) that results in a strong absorption of the electromagnetic field at high frequencies, in particular above 6 GHz.

Moreover, similarly to other prior art solutions, the measurement procedure used in WO2017/0173350 relies on sampling of the transmitted field in a plurality of space points defined by positions of the sensors in the array of sensors (SENS). This may cause inaccuracies due to the fixed mesh of the sampling points dictated by the array of sensor topology and due to the additional postprocessing steps of digital integration of the measured quantities in order to compute a dosimetric quantity defined for a given surface area or volume.

The high EM losses may sacrifice the accuracy of the measurements and reduce the signal-to-noise ratio (SNR). In order to increase the SNR, that is a critical parameter for low-power measurements, it is necessary to increase either the sensitivity of sensors or the level of the transmitted electromagnetic signal. The latter is usually preferred as it allows to deal with a higher noise level. These limitations can be critical in terms of accuracy and cost of the dosimetry device for compliance testing of the 5^{th} and beyond generations of wireless devices.

Therefore, there is a need for an improved device for electromagnetic dosimetry that can be used to carry out measurements faster and more precisely than previous solutions especially at frequencies above 6GHz.

It is an object of the present invention to provide an electromagnetic dosimetry device which can enhance the intensity of the electromagnetic field transmitted through the phantom and allows to compensate the strong attenuation of the electromagnetic fields at high frequencies.

Another aim of the present invention is to propose a device which integrates directly the spatial averaging function in the phantom structure instead of a commonly used post-processing procedure based on local pointwise electromagnetic field measurements, making easier and faster the implementation of the measurement. Thus, the device permits to avoid cumulation of errors related to the tolerance in the positioning and alignment of different electromagnetic sensors relative to the structure simulating EM response of human tissues.

Another aim of the present invention is to provide a device which is easier and less expensive to manufacture.

### Summary

This disclosure improves the situation.

It is proposed a device for measuring a physical quantity related to an electromagnetic (EM) field emitted by an electromagnetic source, the device configured to simulate at least one EM scattering characteristic of a reference object made of an EM lossy medium, in particular a biological tissue, comprising:
- at least one dielectric layer comprising a top surface oriented to the electromagnetic source and a bottom surface, said layer being at least partly transparent to the EM field emitted by the electromagnetic source;
- at least one aperture focusing element attached to or at least partly embedded in the bottom surface of the dielectric layer, said at least one aperture focusing element configured to focus the EM field incident on the at least one aperture element into a focal zone;
- at least one sensor arranged beneath the at least one aperture focusing element and configured to measure the physical quantity related to the electromagnetic field transmitted through the at least one dielectric layer and the aperture focusing element, said at least one sensor being positioned in the focal zone.

In an embodiment, the device further comprises at least one electrically conductive layer positioned on the bottom surface of the at least one dielectric layer, the aperture focusing element being attached to or embedded in the bottom surface of the conductive layer.

Preferably, the at least one conductive layer further comprises at least one through hole, the at least one through hole being aligned with the at least one aperture focusing element.

In an embodiment, the at least one aperture focusing element comprises at least two alternating zones in a form of concentric rings, a first electromagnetically transparent zone and a second electromagnetically opaque zone configured to generate a focusing effect in the focal zone for the incident electromagnetic field, the electromagnetically opaque zone being made of an absorbing material or a reflecting material for the incident electromagnetic field.

In one embodiment, the at least one aperture focusing element comprises at least one groove formed in the bottoms surface of the at least one dielectric layer, said at least one groove being filled with the electromagnetic opaque material in a manner to form at least two alternating electromagnetic transparent and opaque zones.

In another further embodiment, the at least on aperture focusing element comprises a dielectric layer which is attached to the bottom surface of the at least one dielectric layer, said at least one aperture focusing element comprising at least two grooves formed in said dielectric layer and filled alternatively with a transparent material and an opaque material in a manner to form at least two alternating electromagnetic transparent and opaque zones.

In yet another embodiment, the least one aperture focusing element comprises at least one through hole formed in the at least one conductive layer, said at least one through hole being filled with an electromagnetically transparent material for the incident electromagnetic field in a manner to form at least two alternating electromagnetic transparent and opaque zones.

In yet another further embodiment, the at least one aperture focusing element comprises a dielectric layer which is attached to the bottom surface of the at least one conductive layer, said at least one aperture focusing element comprising at least two grooves formed in said dielectric layer and filled alternatively with a transparent material and an opaque material in a manner to form at least two alternating electromagnetic transparent and opaque zones.

In an embodiment, the at least one aperture focusing element comprises at least two alternating electromagnetically transparent zones made of two different dielectric transparent materials to generate a focusing effect in the focal zone for the incident electromagnetic field.

In one embodiment, the at least one aperture focusing element comprises at least one groove formed in the bottom surface of the at least one dielectric layer, said at least one groove being filled with a dielectric material in a manner to form at least two alternating electromagnetically transparent zones made of two different transparent dielectric materials.

In another embodiment, the at least one aperture focusing element comprises a dielectric layer and is attached to the bottom surface of the at least one dielectric layer, said at least one aperture focusing element comprising at least two grooves formed is said dielectric layer and filled alternatively with a first dielectric transparent material and a second dielectric transparent material in a manner to form at least two alternating electromagnetic transparent zones.

In one further embodiment, the at least one aperture focusing element comprises a dielectric layer and is attached to the bottom surface of the at least one conductive layer, said at least one aperture focusing element comprising at least two grooves formed in said dielectric layer and filled alternatively with a first dielectric transparent material and a second dielectric transparent material in a manner to form at least two alternating electromagnetic transparent zones.

In an embodiment, the at least one aperture focusing element comprises a plurality of phase shifting elements arranged in the XY-plane to produce a phase correcting effect on the electromagnetic field incident on the aperture focusing element to generate a focusing effect in the focal zone.

In another embodiment, the at least one aperture focusing element comprises a plurality of dielectric pillars with sub-wavelength dimensions arranged in the XY-plane to produce a phase correcting effect on the electromagnetic field incident on the aperture focusing element to generate a focusing effect in the focal zone.

In one further embodiment, the at least one aperture focusing element comprises a free-form volumetric refractive lens made of a transparent dielectric material with concave profile, such as plano-convex lens, or a concentric zone lens with each zone characterized by different value of the effective dielectric permittivity to produce a phase correcting effect on the electromagnetic field incident on the aperture focusing element to generate a focusing effect in the focal zone.

Preferably, the device further comprises at least one spacer dielectric layer positioned on the bottom surface of the at least one dielectric layer or on the bottom surface of the conductive layer, the thickness T₃ of the spacer dielectric layer being sensibly equal to the focal length (F) of the at least one aperture focusing element.

In an embodiment, the at least one sensor comprises an electromagnetic sensor operating at a frequency of the electromagnetic source.

In another embodiment, the at least one sensor comprises an electromagnetic sensor operating at a frequency different from that of the electromagnetic source, the device further comprising frequency converter element.

In one further embodiment, the at least one sensor comprises a thermal sensor.

In that case, the device further comprises at least one heat converting element placed in the focal zone, the at least one thermal sensor being positioned in direct contact with the at least one heat converting element.

In a preferred embodiment, the device comprises a plurality of aperture focusing elements and a plurality of sensors, each sensor being placed in a focal zone of at least one an aperture focusing element.

### Brief Description of Drawings

Other features, details and advantages will be shown in the following detailed description and on the figures, on which:
**Fig. 1**

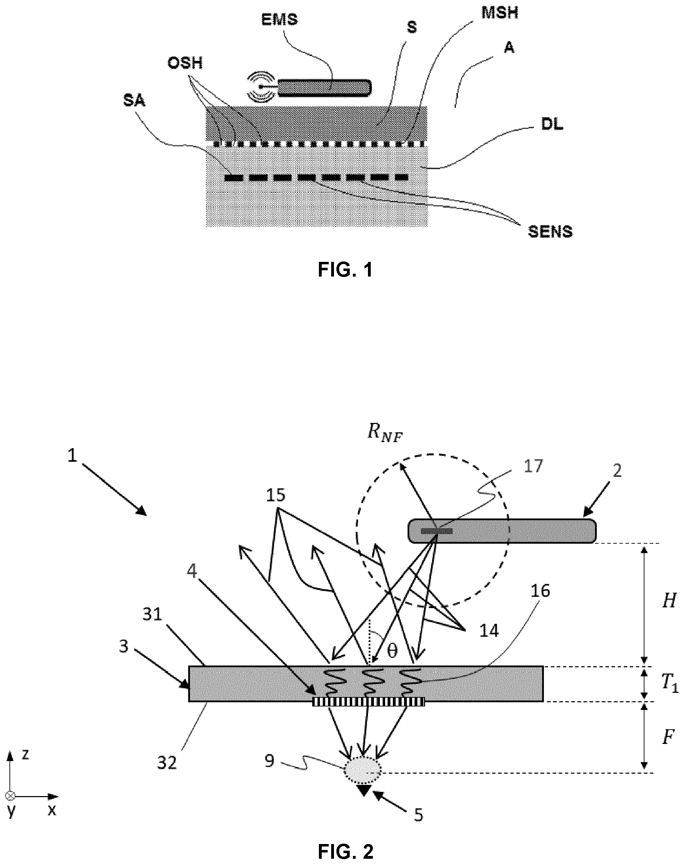

   [Fig. 1] Figure 1 is a schematic illustration of a cross-sectional view of a device for electromagnetic dosimetry of the prior art.
**Fig. 2**
   [Fig. 2] Figure 2 is a schematic illustration of a cross-sectional view of one embodiment of a device for electromagnetic dosimetry.
**Fig. 3**

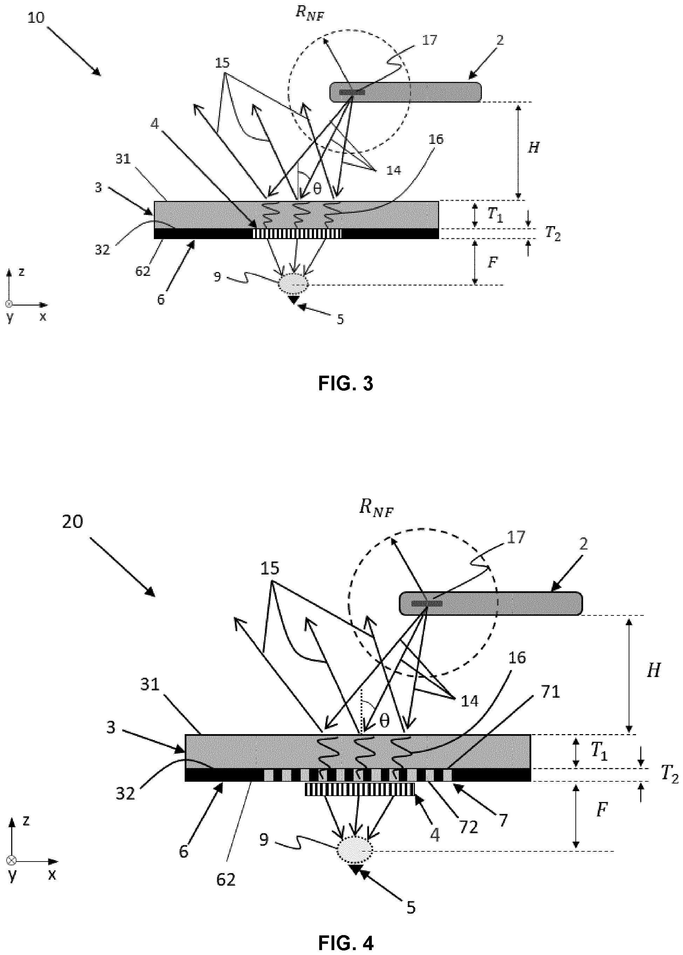

   [Fig. 3] Figure 3 is a schematic illustration of a cross-sectional view of another embodiment of a device for electromagnetic dosimetry.
**Fig. 4**
   [Fig. 4] Figure 4 is a schematic illustration of a cross-sectional view of still another embodiment of a device for electromagnetic dosimetry.
**Fig. 5A**

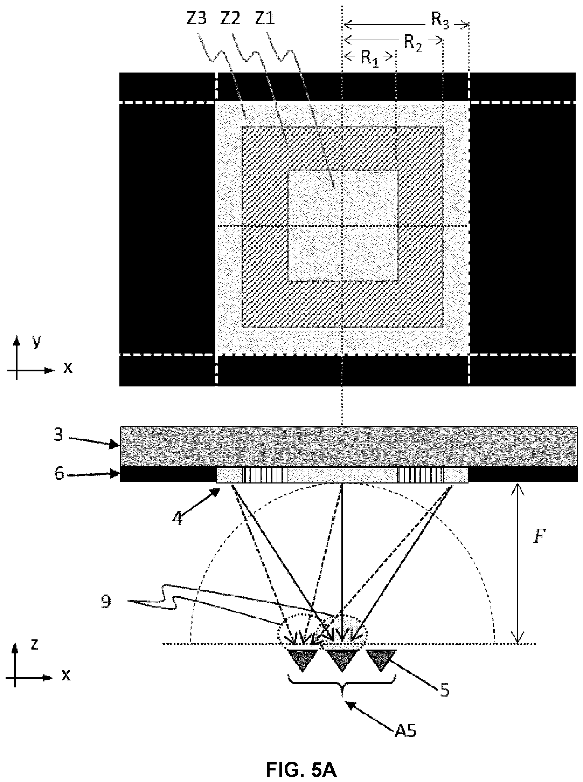

   [Fig. 5A] Figure 5A schematically illustrates in detail a bottom view and a side view of an example of an aperture focusing element embedded in the bottom surface of the conductive layer of the device of figure 3.
**Fig. 5B**

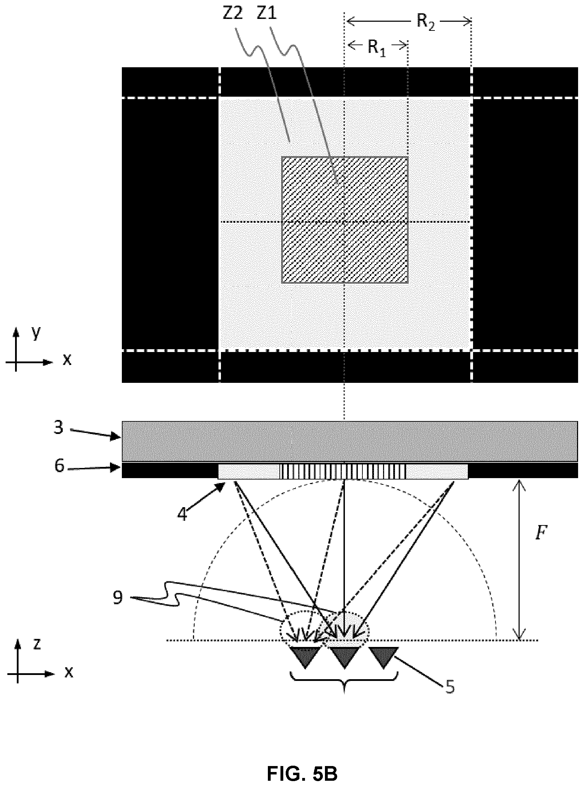

   [Fig. 5B] Figure 5B schematically illustrates in detail a bottom view and a side view of another example of an aperture focusing element embedded in the bottom surface of the conductive layer of the device of figure 3.
**Fig. 6A**

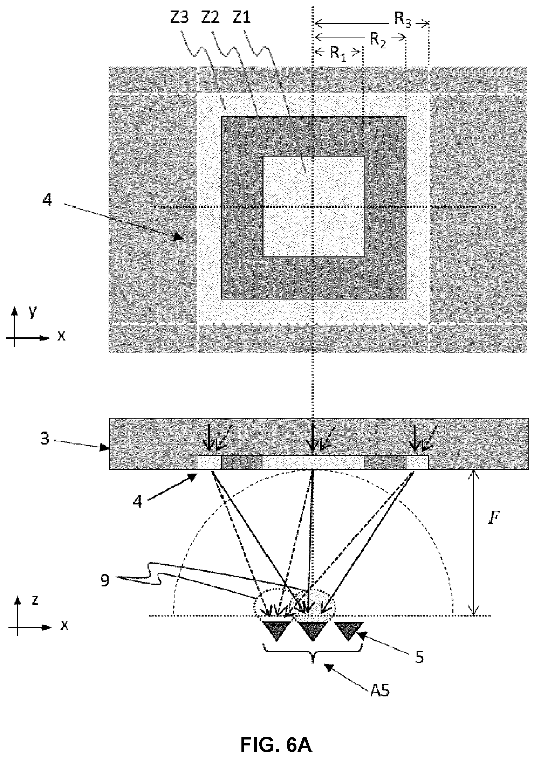

   [Fig. 6A] Figure 6A schematically illustrates in detail a bottom view and a side view of an example of an aperture focusing element embedded in the bottom surface of the dielectric layer of the device of figure 2.
**Fig. 6B**

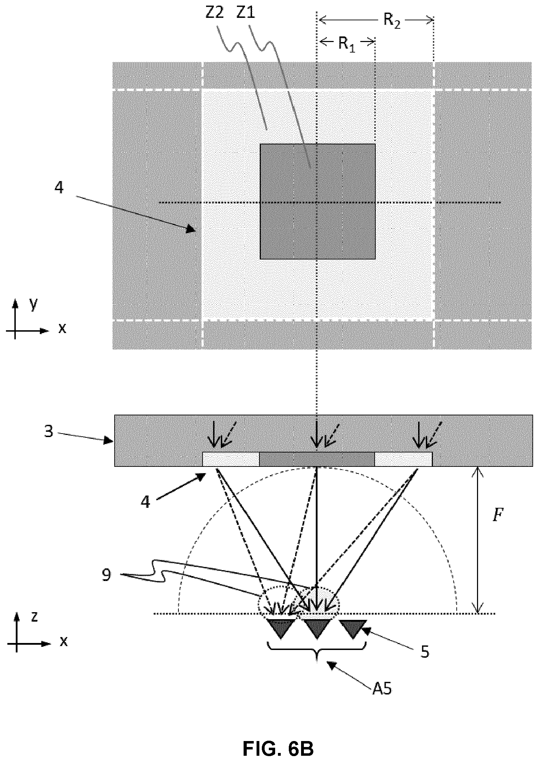

   [Fig. 6B] Figure 6B schematically illustrates in detail a bottom view and a side view of another example of an aperture focusing element embedded in the bottom surface of the dielectric layer of the device of figure 2.
**Fig. 7**

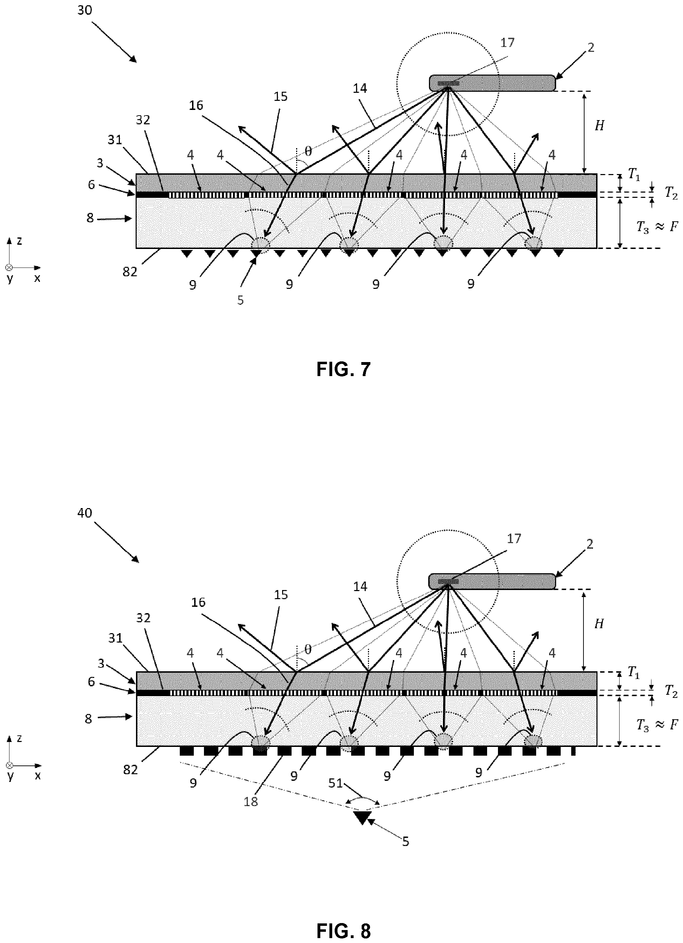

   [Fig. 7] Figure 7 is a schematic illustration of a cross-sectional view of yet another embodiment of a device for electromagnetic dosimetry.
**Fig. 8**
   [Fig. 8] Figure 8 is a schematic illustration of a cross-sectional view of still another embodiment of a device for electromagnetic dosimetry.

### Description of Embodiments

The terms "top," "bottom," "over," "under," "between," "on", and other similar terms as used herein refer to a relative position. The relative position of the terms does not define or limit the layers to a vector space orientation.

To facilitate understanding, identical reference numerals have been used, where possible, to designate identical elements that are common to the figures. It is contemplated that elements disclosed in one embodiment may be beneficially utilized on other embodiments without specific recitation.

In the present disclosure, the term "layer" refers to a structure having a constant thickness or a variable thickness. The layer may be planar or curved. In particular, the layer may be shaped to reproduce a 3D form of a part of a human body, e.g. head or hand. The layer may be shaped to form a closed loop such a side wall of a cylindrical object.

In the present disclosure, the term "dosimetric quantity" refers to any metric used to quantify the electromagnetic exposure levels, including power density, energy density, specific absorption rate, specific energy absorption, electric field strength, magnetic field strength, electric voltage or current defined with respect to an averaging surface area or volume.

In the present disclosure, the term "electrically conductive layer" refers to a layer made of electrically conductive material having electrical conductivity *σ* ≥ 10³ S/m.

In the present disclosure, the term "dielectric layer" refers to a layer made of thermally conductive and electrically insulating material having electric conductivity *σ* < 10³ S/m.

With reference to figure 2, a device 1 for electromagnetic dosimetry according to an embodiment of the present disclosure will now be described. The device 1 is placed in an orthogonal spatial coordinate system (XYZ).

The device is advantageously configured to reproduce an electromagnetic response of a reference object; in particular the EM reflection characteristics at the air/dielectric interface at the surface of a reference object, and to measure a physical quantity related to the electromagnetic field incident on the device. The reference object is made of an electromagnetically lossy medium such as a biological tissue, and in particularly a human skin tissue. The measured physical quantity may be proportional to the amplitude of the EM field, intensity or power density of the EM field incident on or transmitted through the air/dielectric interface.

The device comprises at least one dielectric layer 3 extending sensibly along a plane (XY). The dielectric layer defines two main surfaces, a top surface 31 and a bottom surface 32 which extends along the plane (XY). In the example of figure 2, the device comprises one dielectric layer 3.

The dielectric layer 3 may be made of any suitable material to simulate the reflection characteristics of a reference object, e.g. human tissues. As non-limiting examples, the dielectric layer may be made of any solid dielectric material characterized by a relevant value of the complex dielectric permittivity, such as plastic, polymer, ceramics, glass. The one skilled in the art will easily adapt the different values of the complex permittivity to the embodiments described in relation with the present invention.

In one example, the dielectric layer may be made of a dielectric material which is mixed with another dielectric material or electrically conductive material. The conductive material is preferably chosen as having high electrical conductivity provided in a form of small elements with size smaller than 1/4 of the wavelength of the electromagnetic wave in the dielectric medium of layer 3.

In another example, the dielectric layer 3 may be an amorphous or gel type dielectric material doped with conductive filling, forming a suspension-type composite material. The percentage of the conductive filling may be varied in order to reproduce the electromagnetic response of a reference object, such as the EM reflection characteristics at the air-dielectric interface of a human skin tissue.

The thickness of the dielectric layer T₁ is preferably comprised between λ₁/10 and 10λ₁, where *λ*₁ is the wavelength of the EM field in the medium of the dielectric layer 3. For instance, the thickness of the dielectric layer T₁ may be about 1 mm at 60 GHz. The optimal thickness of the layer 3, leading to the desired EM reflection from its surface, depends on the complex permittivity of the medium of said layer 3.

In another embodiment, at least one dielectric layer 3 forms a closed or partly closed shell filled in with a medium, e.g. liquid, gel, foam, or gas. This structure is particularly adapted to simulate the case of a part of the human body, e.g. head-like phantoms. The medium may be chosen to act as the brain and the top surface may present a concave surface in a manner to simulate the form of a head. Alternatively, the medium can be used solely as a mechanical support and/or a host medium for the at least one sensor element 5 placed beneath the dielectric layer 3.

The device further comprises an aperture focusing element 4, positioned on or at least partly embedded in the bottom surface 32 of the dielectric layer 3. The aperture focusing element 4 is configured to confine the electromagnetic field incident on the aperture focusing element 4 into a focal zone 9. The device 1 further comprises a sensor 5 arranged beneath the aperture focusing element 4 and placed in the focal zone 9 to measure a physical quantity related to the total electromagnetic field incident on the aperture of the focusing element 4. In other words, the sensor 5 measures a physical quantity related to a dosimetric quantity defined with respect to an averaging volume or to an averaging surface area. In one embodiment, the dimension of surface area of the aperture focusing element is preferably selected equal to or being a multiple of the averaging volume or the averaging surface area defined in the definition of the dosimetric quantity.

The physical quantity may be related to the electromagnetic field transmitted through the dielectric layer 3 and incident on the aperture focusing element 4. The physical quantity may be also related to the temperature or heat generated in the focal zone 9 due to absorption of the transmitted electromagnetic field, related to the intensity of the EM field. The physical quantity may be related to the electromagnetic field radiated by a frequency converting element exposed to the transmitted electromagnetic field.

The aperture focusing element 4 is at least partly embedded in the bottom surface 32 of the dielectric layer 3. In another example, the aperture focusing element 4 is attached to the bottom surface 32 of the dielectric layer 3 and extends from the bottom surface 32 of the dielectric layer 3 towards the sensor 5.

In a preferred embodiment, the aperture element 4 is aligned with the sensor 5 along the direction of the electromagnetic wave propagation.

In the embodiment of figure 2, the device comprises one aperture focusing element 4 and one sensor 5. In another embodiment, the device may comprise more than one aperture focusing element 4 and more than one sensor 5. As shown in figures 5A-6B, the EM field incident on the aperture of the aperture focusing element 4 is collected and focused into a single focal spot. The focal spot forms along a focal plane, depending on the EM field wave incident angle from the electromagnetic field source 2. Thus, the focal zone produced by the aperture focusing element is aligned with at least one sensor 5. As shown in figure 7, the aperture focusing elements 4 and the sensors may be arranged into a regular pattern.

An electromagnetic field source 2 is disposed at a distance H to the device 1. This distance H is preferably larger than the antenna near-field zone represented in figure 2 by a circle. For an electrically small antenna, the reactive near-field zone is approximately defined with respect to the wavelength as R_{NF} = λ₀ / 2π, where λ₀ is the wavelength in vacuum. For example, at 60 GHz, the distance R_{NF} is about 0.8 mm.

The source 2 may be a mobile phone or any other wearable or portable wireless device operating above 6 GHz. The one skilled in the art will easily adapt the value of this distance H in order to guarantee an accurate compliance test, representative of a realistic use case situation, such as a mobile phone close to the head of the user. The distance H and the position of the wireless device under test depend on the intended use cases defined by manufacturer of the wireless device. For instance, said distance can vary in the range from a few mm (for a smartphone close to a head) to a few tens of cm (for a hand-held device). The source comprises one or more antennas connected to the body of the source for transmitting and receiving electromagnetic signals.

As shown in figure 2, the electromagnetic field source 2 comprises an antenna 17 which emits an electromagnetic field represented by a circle with a center coinciding with a phase center of the antenna 17. A portion of the electromagnetic wave 14 provided by the source 2 illuminates the top surface 31 of the device 1. The source may be positioned to direct the EM radiation to preferential locations of the device.

The electromagnetic source 2 may operate at frequencies in a range from about 6 GHz to about 300 GHz, however the teaching of this invention can be scaled to other frequency bands, thanks to the scalability of the Maxwell equations. In particular, it can be downscaled to the microwave frequency range or upscaled to at least the THz frequency range.

As shown in figure 2, the electromagnetic wave 14 emitted by the source 2 is incident on the top surface 31 of the dielectric layer 3 with an oblique angle of incident θ and the incident electromagnetic wave is partially reflected by the top surface 31 in a direction forming an opposite angle with the normal to the top surface of the dielectric layer 3. The reflected EM wave is designated by the numeric reference 15. A portion of the EM wave that is not reflected at the air-dielectric interface associated with the top surface 31 propagates through the dielectric layer 3, from the top surface 31 to the bottom surface 32, and is partly absorbed by said dielectric layer. The electromagnetic wave 16 transmitted through the dielectric layer 3 is then focused by the aperture focusing element 4 into a focal zone 9. In the present disclosure, the focal zone refers to a zone characterized by an enhanced electromagnetic field achieved due to the focusing phenomenon.

Thanks to the presence of the aperture focusing element 4, the device of the present disclosure allows the compensation the unavoidable EM losses in the structure, which acts as an equivalent phantom, and permits to improve the post-processing procedure.

The sensor 5 of the device 1 is positioned close to the focal zone 9 to measure a physical quantity related to the transmitted electromagnetic field. In other words, the sensor 5 is positioned at a focal length F from the aperture focusing element 4.

The sensor 5 measures a physical quantity related to the transmitted electromagnetic field and forms an electrical signal. The signal is then transmitted to a processing unit which is configured to calculate the exposure level at the surface of the dielectric layer 3 by the source 2 from the signals transmitted by the sensor 5.

The aperture focusing element 4 is configured to focus the electromagnetic field incident on the aperture element into a focal spot aligned with position of the sensor 5. The aperture focusing element 4 permits to compensate the attenuation of the intensity of the electromagnetic field along the propagation path of the electromagnetic wave through the dielectric layer 3.

The figure 3 is a schematic illustration of a cross-sectional view of another embodiment of an electromagnetic dosimetry device 10, which may be used in place of the device 1 of figure 2. The dosimetry device 10 is similar to the dosimetry device 1 of figure 2.

In the embodiment of figure 3, the structure which simulates the human tissues comprises at least one dielectric layer 3 and at least one electrically conductive layer 6. The dielectric layer has a thickness T₁ greater than the thickness T₂ of the conductive layer. The thickness of the conductive layer T₂ is preferably larger than the penetration depth of the EM field into the medium of the conductive layer (*T*₂ ≥ *δ*, where *δ*∼[*πfµσ*]^{-1/2}, *f* is frequency of the EM field, *µ* = *µ*₂*µ*₀ is permeability, and *σ* is the electrical conductivity of the medium of the conductive layer 6). For a good conductor in the GHz frequency range, the thickness of the conductive layer 6 can be a fraction of millimeter.

The aperture focusing element 4 is embedded in the bottom surface 62 of the conductive layer. The bottom surface 32 of the dielectric layer 3 is in contact with the top surface of the conductive layer 6. The aperture focusing element 4 extends through the conductive layer 6 covering the dielectric layer 3. The bottom surface of the aperture focusing element 4 is flush in relation with the bottom surface 62 of the conductive layer 6. In other word, the aperture focusing element 4 is fully embedded in the conductive layer 6.

The conductive layer 6 contributes simultaneously to reproducing a desired EM response from the top surface of the device, similar to that of a reference object, and to the function of the aperture focusing element to focus the electromagnetic field incident on the aperture focusing element. The conductive layer 6 may be made of any conductive material adapted to reflect, at least partly, the incident electromagnetic field.

The aperture focusing element 4 is configured to confine the electromagnetic field incident on the aperture focusing element 4 into a focal zone 9. The device 1 further comprises a sensor 5 arranged beneath the aperture focusing element 4 and placed in the focal zone 9 to measure a physical quantity related to the total electromagnetic power incident.

In a preferred embodiment, the aperture element 4 is aligned with the sensor 5 along the direction of the electromagnetic wave propagation.

In the embodiment of figure 3, the device comprises one aperture focusing element 4 and one sensor 5. In another embodiment, the device may comprise more than one aperture focusing element 4 and more than one sensor 5. In this configuration, the focal zone produced by each aperture focusing element is aligned with at least one sensor 5.

The figure 4 is a schematic illustration of a cross-sectional view of still another embodiment of the proposed device for electromagnetic dosimetry 20, which may be used in place of the device 1 of figure 2 or device 10 of figure 3.

In the embodiment of figure 4, the structure which simulates human tissues comprises at least one dielectric layer 3 and at least one conductive layer 6. In addition, the conductive layer 6 comprises at least one through hole 7 extending from the bottom surface 32 of the dielectric layer 3, through the conductive layer 6. By through hole, it is understood that the through hole 7 has a bottom 71 formed by a portion of the bottom surface 32 of the dielectric layer 3 and an open end 72 opposite its bottom. The through hole has walls extending from the bottom to its open end, wherein each wall is formed by the thickness of the electrically conductive layer 6.

In a preferred embodiment, the conductive layer 6 comprises an array of through holes 7.

These through holes 7 form a transparent zone for the incident electromagnetic field 16. The aperture focusing element 4 is positioned on the bottom surface 62 of the conductive layer and aligned with the array of through holes.

The aperture focusing element 4 is configured to confine the electromagnetic field incident on the aperture focusing element 4 into a focal zone 9. The device 20 further comprises a sensor 5 arranged beneath the aperture focusing element 4 and placed in the focal zone 9 to measure a physical quantity related to the total electromagnetic power incident on the aperture of the focusing element 4. Thus, the sensor 5 is aligned with the aperture focusing element 4 and the array of through holes 7.

The shape of the trough holes 7 is indifferent, i.e., it can be a square, a rectangle or circular. The shape is preferably chosen to make the alignment easier with the electromagnetic focusing element. The minimum size of the through hole is defined with respect to its contour line whose length shall be at least equal to a half of the wavelength of the EM field in the medium of the dielectric layer 3. In one embodiment, the through holes can merge forming a through hole mesh surrounding isolated islands made of a conductive material representing the layer 6. The surface ratio between the surface area of the at least one through hole to the total surface area of the aperture focusing element can vary between 20 and 80 percent.

With reference to figures 5A, 5B, 6A and 6B, the function and the different embodiments of the aperture focusing element 4 is detailed below.

Thanks to the aperture focusing element 4, the proposed device allows to measure in a single step a physical quantity related to the total electromagnetic power incident on a surface area of the dielectric layer that can be beneficially selected equal to or multiple of the averaging surface area in the definition of the dosimetric quantity measured by the device.

The aperture focusing element 4 may be represented by a Fresnel-type zone plate lens, comprising at least two alternating zones, a first electromagnetically transparent zone, and a second electromagnetically opaque zone at the operational frequency of the source 2. In the present disclosure, the term "alternating" is used in the sense of a repeated pattern of transparent/opaque zones.

In the present disclosure, the term "electromagnetically transparent zone" refers to a zone made of a material through which the electromagnetic field from the source 2 passes. The transparent zone referenced by Z1 and Z3 in figure 5A, by Z2 in figure 5B, and by Z1 and Z2 in figures 6A or 6B may be made of or filled in with a dielectric material having a refractive index different from that of the dielectric material of the dielectric layer 3.

In the present disclosure, the term "electromagnetically opaque zone" refers to a zone made of a material that blocks the transmission of the electromagnetic field from the source. The opaque zone may be made of an absorbing material or a reflecting material.

Thus, the aperture focusing element 4 allows the EM opaque zone to contribute to reproducing the EM scattering characteristics of the reference object, while the EM transparent zone contributes to the focusing effect.

Figure 5A is a schematic illustration of a bottom view and a side view of one embodiment of an aperture focusing element 4.

Figure 5A represents the aperture focusing element 4 with two EM transparent zones Z1, Z3 and one electromagnetically opaque zone Z2 alternatively arranged to form a concentric pattern to generate a focusing effect for the incident electromagnetic field. The device comprises a plurality of sensors 5 forming an array of sensors A5 placed in the focal plane. The transmitted EM field is then focused by the aperture focusing element 4 into a focal spot 9 whose position is aligned with the position of a sensor 5 among a plurality of sensors 5. In figure 5A, the dashed lines represent the optical path of the transmitted EM field when the EM wave emitted by the source is incident on the top surface of the dielectric layer 3 with an oblique angle, and the solid lines represent the optical path of the transmitted EM filed when the EM wave emitted by the source is incident on the top surface of the dielectric layer at the normal incidence. As shown in figure 5A, depending on the EM wave incident angle, the focal zone 9 produced by the aperture focusing element (AFE) is formed along the focal plane.

Figure 5B is a schematic illustration of a bottom view and a side view of another embodiment of an aperture focusing element 4.

Figure 5B represents the aperture focusing element 4 with one electromagnetically opaque central zone Z1 and one electromagnetically transparent zone Z2, surrounding the central opaque zone Z1, both zones configured together to generate a focusing effect for the incident electromagnetic field in the focal zone 9.

The transparent and opaque zones may have any desirable shape in the plane (XY) forming concentric rings. The illustrative example of figure 5A shows two square transparent zones Z1, Z3 and one square opaque zone Z2. In another example, the transparent and opaque zones may be represented by circular rings.

In a preferred embodiment, the surface of each zone is intended to be constant over the aperture of the focusing element 4 with the size of the central zone Z1 at least equal one half of the wavelength of the EM field in the medium of the dielectric layer 3 (*R*₁ ≥ *λ*₁/4).

The aperture focusing element 4 may have any desirable number of alternating transparent and opaque zones in a manner to focus the incident electromagnetic field into a focal zone 9. The central zone can be transparent or opaque zone. The minimum number of zones needed to produce a focusing effect is two if the central zone is opaque and three if the central zone is transparent.

In a preferred embodiment, the overall size of the surface area occupied by the aperture focusing element 4 is equal to or a multiple of the averaging area defined by a corresponding specification for the exposure limit compliance testing of wireless devices, by a corresponding standard, guideline or any other related regulation. The one skilled in the art will easily adapt the value of overall size of the surface area occupied by the aperture focusing element 4 in order to guarantee an accurate compliance test, representative of realistic use case situation of the wireless device.

In the embodiment of the figure 2 wherein the structure which stimulates human tissues comprises at least one dielectric layer, the aperture focusing element 4 is embedded in the bottom surface 32 of the dielectric layer 3. At least one of the two types of the alternating transparent and opaque zones may be formed by a plurality of grooves on the bottom surface 32 of the dielectric layer 3. In one example, the grooves are filled in with a material absorbing or reflecting the incident electromagnetic field, while the transparent zones are formed by the material of the dielectric layer, forming thus a plurality of alternating transparent and opaque zones. Alternatively, two sets of grooves can be engraved in the bottom surface of the dielectric layer 3. One set of grooves are filled in with an opaque or reflecting material to form opaque zones and the other set of grooves are filled in with a dielectric material to form transparent zones. The depth of each set of grooves can be different.

Alternatively, the aperture focusing element 4 forms an element which is distinct from the dielectric layer 3 of the device and attached on the bottom surface 32 of the dielectric layer 3. For example, the aperture focusing element 4 comprises a substrate made of a dielectric material transparent to the EM field emitted by the source 2 and a plurality of grooves is formed in the substrate. One set of grooves are filled in with a material transparent to the incident electromagnetic field and another set of grooves are filled in with a material absorbing or reflecting the incident electromagnetic field to form the opaque zones.

In the embodiment of figure 3 wherein the structure which simulates human tissues further comprises one conductive layer 6 arranged on the bottoms surface 32 of the dielectric layer 3, the transparent zones may be formed by a plurality of through holes in the bottom surface 62 of the conductive layer 6. The depth of the through holes are equal to the thickness of the conductive layer 6, thus forming through holes 7 as case of figure 3, while the opaque zones are formed by the conductive layer 6. In an alternative example, the through holes may be filled with a dielectric material transparent to the incident electromagnetic field (solid, liquid, gas).

In the embodiment of figure 4 wherein the conductive layer 6 comprises an array of through holes 7, the aperture focusing element 4 forms an element which is distinct from the conductive layer 6 and attached to the bottom surface 62 of the conductive layer 6. For example, the aperture focusing element 4 comprises a substrate made of a transparent dielectric material and a plurality of grooves is formed in the substrate. The grooves are then filled alternatively with a material transparent to the incident electromagnetic field and with a material opaque to the incident electromagnetic field. The aperture focusing element 4 is aligned with the array of through holes 7 and the sensor 5.

In another embodiment, the aperture focusing element 4 attached to the conductive layer 6 can be implemented in a form of a volumetric lens, e.g. a plano-convex lens having a desired size and shape of the receiving aperture and a focal length aligned with the position of the sensor 5.

The figures 6A and 6B illustrate another embodiment of the aperture focusing element 4. The at least one aperture focusing element 4 comprises at least two alternating electromagnetically transparent zones Z1 and Z2 to generate a focusing effect for the incident electromagnetic field. In other words, the aperture focusing element 4 comprises at least a first transparent zone Z1 made of a first dielectric material with a first refractive index n₁ and at least a second transparent zone Z2 made of a second dielectric material with a second refractive index n₂. In this configuration, the minimum number of transparent zones made of different dielectric materials needed to produce a focusing effect is two.

In figures 6A and 6B, the aperture focusing element 4 is embedded in the bottom layer of the dielectric layer 3, as shown in figure 2, wherein the structure which simulates human tissues comprises one or more dielectric layer 3.

When the electromagnetic field is incident on the aperture focusing element 4, a portion of the electromagnetic wave passes through the zone Z1 and a portion of the electromagnetic wave passes through the zone Z2. The wave fronts have different phase velocities related to the different dielectric permittivity of the corresponding media. The alternating transparent zones Z1 and Z2 generate a constructive interference between the electromagnetic wave front crossing through the zone Z1 and Z2 in a focal point 9.

In the embodiment of the figure 2 wherein the structure which stimulates human tissues comprises at least one dielectric layer 3, the aperture focusing element 4 is embedded in the bottom surface 32 of the dielectric layer 3. A plurality of grooves is formed in the bottom surface 32 of the dielectric layer. In one example, the grooves are then filled in with another dielectric material different from the dielectric material of the dielectric layer 3 to form the first set of transparent zones, while the second set of transparent zones is formed by the dielectric material of the dielectric layer 3. The dielectric material used to fill in the grooves can be the host medium, e.g. gas or liquid. In another example, the grooves are filled alternatively with a first dielectric material transparent to the incident electromagnetic field and a second dielectric material transparent to the incident electromagnetic field.

Alternatively, the aperture focusing element 4 forms an element which is distinct from the dielectric layer 3 of the device and is attached on the bottom surface 32 of the dielectric layer 3. For example, the aperture focusing element 4 comprises a dielectric layer and a plurality of grooves is formed in the dielectric layer. One set of grooves is filled in with a first dielectric material transparent to the incident electromagnetic field and another set of grooves is filled in with a second dielectric material transparent to the incident electromagnetic field.

In the embodiment of figure 4 wherein the conducive layer 6 comprises an array of through holes 7, the aperture focusing element 4 forms an element which is distinct from the conductive layer 6 and is attached on the bottom surface 62 of the conductive layer 6. For example, the aperture focusing element 4 comprises a dielectric layer and a plurality of grooves is formed in the dielectric layer. The grooves are then filled alternatively with a first dielectric material transparent to the incident electromagnetic field and a second dielectric material transparent to the incident electromagnetic field. The aperture focusing element 4 is aligned with the array of through holes 7 and the sensor 5.

In another embodiment of the device in the figure 2, 3, or 4, the at least one aperture focusing element 4 may comprise a plurality of phase shifting elements configured to provide a desired phase-correcting effect of the electromagnetic wave fronts, leading to formation of a wave front converging towards a focal zone 9. For example, the phase shifting elements may comprise metal patches or split-ring resonators arranged in one plane or in at least two parallel planes, forming a transmit-array lens.

In still another embodiment of the device in the figure 2, 3, or 4, the at least one aperture focusing element 4 comprises a plurality of dielectric pillars having a cylindrical, conical or cuboidal form with a largest dimension in XY plane being less or equal to a quarter of the wavelength in the material of the pillar and the height along z-axis being equal at least a quarter of the wavelength in the material of the pillar, forming a so-called metasurface lens. The pillars are configured in terms of size, cross-sectional shape, rotation in XY-plane, or orientation relative to the propagation direction of the incident electromagnetic field to generate a desired phase-correcting effect on the wave front of the electromagnetic field 16 incident on the aperture of the focusing element 4, leading to formation of a focal zone 9.

In yet another embodiment of the device in the figure 2, 3, or 4, the at least one aperture focusing element 4 comprises a free-form volumetric refractive lens. Its surface profile and/or the gradient of the effective permittivity along the aperture of said lens can be controlled in a manner to confine the electromagnetic field into a focal zone. For instance, it can be a plano-convex lens or a planar lens with a co-centric variation of the material density controlled, for instance, by distributed holes or material filling factor, whose volumetric ratio defines the effective value of the bulk material.

The figure 7 is a schematic illustration of a cross-sectional view of still another embodiment of a device for electromagnetic dosimetry 30.

The device of this embodiment is similar to that of figure 3. The structure which simulates the human tissues comprises at least one dielectric layer 3 and at least one electrically conductive layer 6. The dielectric layer has a thickness T₁ that is typically greater than the thickness T₂ of the conductive layer. The device comprises a plurality of aperture focusing elements 4 formed in or attached to the bottom surface 62 of the conductive layer 6 as explained in relation to figure 3 and 4, respectively.

In a preferred embodiment, the aperture focusing elements 4 are arranged in a regular pattern in the bottom surface 62 of the conductive layer 6. The aperture focusing elements generate a plurality of focal zones 9 along a focal plane. The device comprises a plurality of independent sensors 5 distributed in the focal plane.

In another embodiment, the plurality of aperture focusing elements are arranged in a regular pattern and forms an element distinct from the conductive layer 6. The plurality of focusing elements is attached to the bottom surface 62.

In yet another embodiment, the aperture focusing elements can be directly attached to or formed in the bottom surface 32 of the dielectric layer 3 as explained in the relation to figure 2, without comprising a conductive layer 6.

In the embodiment of figure 7, the device further comprises a spacer layer 8 between the structure which simulates human tissues and the sensors 5. The spacer layer 8 may be made of a dielectric material chosen in a manner to limit the attenuation of the electromagnetic field in the spacer layer 8. The thickness T₃ of the spacer layer is sensibly equal to the focal length F.

In case of the embodiment of figure 2 wherein the structure simulating human tissues comprises one or more dielectric layer 3, the spacer layer 8 is attached directly to the bottom surface 32 of the dielectric layer 3.

In case of the embodiment of figure 3 and figure 4 wherein the structure simulating human tissues further comprises a conductive layer 6 positioned on the bottom surface 32 of the dielectric layer 3, the spacer layer 8 is attached directly to the bottom surface 62 of the conductive layer. In this case, the aperture focusing element 4 can be at least partly embedded in the spacer layer 8.

In one embodiment, the array of sensors 5 may comprise a plurality of antenna elements operating in the same frequency range of the electromagnetic source. The antenna elements are configured to measure directly the focused electromagnetic field in the focal zone. For instance, the sensors may be represented by a waveguide probe or by an aperture-coupled microstrip patch, resonant slot, or cross-dipole antenna printed on a Printed Circuit Board (PCB) structure supporting the antenna feeding networks that is attached to the bottom surface 82 of the spacer layer 8.

In another embodiment, the array of sensors 5 may comprise a plurality of thermal sensors. The thermal sensors may be a thermocouple or an optical fiber thermometer configured to measure the heat generated due to absorption of the transmitted electromagnetic field in the focal zone. The optical fiber thermometer comprises a thermosensitive element placed in the focal zone. For example, the thermosensitive element may be a GaAs semiconductor crystal mounted on the tip of an optical fiber.

In a variant of this embodiment, the device comprises additional heat converter elements placed in the focal zone of the aperture focusing elements. The heat converter elements are capable of absorbing and converting the electromagnetic field incident on the heat converter element into heat. Each thermal sensor is put in direct contact with the heat converter element. This embodiment allows to enhance the dynamic range of the measured physical quantity corresponding to a temperature rise and thus to improve the signal to noise ratio (SNR) of the sensor 5.

In yet another embodiment, the at least one sensor 5 operates in a frequency range different from that of the electromagnetic source 2. In other words, the electromagnetic sensor 5 is capable of measuring electromagnetic field emitted at a frequency f2 different from the operational frequency of the source 2. In this embodiment illustrated in figure 8, the device 40 further comprises an array of frequency converting element 18 configured to convert the incident electromagnetic field at frequency f₁ into electromagnetic field at frequency f2, e.g. infrared radiation. These frequency converting elements 18 are placed in the focal plane of the aperture focusing elements. The at least one sensor 5 represents an image sensor (e.g. infrared image sensor), placed at a certain distance from the bottom surface 82 of the support layer 8, with a field of view 51 covering the plurality of the frequency converting elements 18.

This frequency converter permits to improve the SNR of the sensor 5 operating at a frequency f2 different from the frequency f1 of the EM source 2 by avoiding the noise due to the multi-path scattering of the EM field emitted by the EM source 2. In a preferred embodiment, the heat converters may act as such a frequency converting element, converting the radio frequency range to infrared (IR) range.

In another embodiment, the frequency converting element may be represented by a liquid crystal based element or a light emitting diode (LED) capable of generating visible light when exposed to electromagnetic field. In one embodiment, such frequency converting elements can be triggered by a transistor-type switch calibrated to respond to the electromagnetic field emitted by the source 2 used for tuning the intensity or frequency of the emitted light. In this embodiment, the electromagnetic sensor is an optical electromagnetic sensor placed at a certain distance beneath the focal plane of the aperture focusing element, e.g. image sensor with a field of view aligned to simultaneously cover all the frequency converting elements 18.

In a preferred embodiment, it may be beneficial to select the operational frequency range of the frequency converting element 18 to be in the visible optical range and calibrate it in such a way that the increase of the incident power density leads to continuous shift of the color, e.g. with blue color representing a low power exposure level and red a higher level of the EM exposure (or vice-versa). Furthermore, a certain color within the spectrum of visible light can be associated with a threshold defined by a corresponding standard as the maximum allowed exposure level.

## Claims

1. Device (1) for measuring a physical quantity related to an electromagnetic (EM) field emitted by an electromagnetic source (2), the device configured to simulate at least one EM scattering characteristic of a reference object made of an EM lossy medium, in particular a biological tissue, comprising:
- at least one dielectric layer (3) comprising a top surface (31) oriented to the electromagnetic source (2) and a bottom surface (32), said layer (3) being at least partly transparent to the EM field emitted by the electromagnetic source (2);
- at least one aperture focusing element (4) attached to or at least partly embedded in the bottom surface (32) of the dielectric layer (3), said at least one aperture focusing element (4) configured to focus the EM field incident on the at least one aperture element (4) into a focal zone (9);
- at least one sensor (5) arranged beneath the at least one aperture focusing element (4) and configured to measure the physical quantity related to the electromagnetic field transmitted through the at least one dielectric layer (3) and the aperture focusing element (4), said at least one sensor (5) being positioned in the focal zone (9).

2. Device of claim 1, further comprising at least one electrically conductive layer (6) positioned on the bottom surface (32) of the at least one dielectric layer (3), the aperture focusing element (4) is attached to or embedded in the bottom surface (62) of the conductive layer (6).

3. Device of claim 2, wherein the at least one conductive layer (6) further comprises at least one through hole (7), the at least one through hole (7) being aligned with the at least one aperture focusing element (4).

4. Device of any of claims 1 to 3, wherein the at least one aperture focusing element (4) comprises at least two alternating zones in a form of concentric rings, a first electromagnetically transparent zone and a second electromagnetically opaque zone configured to generate a focusing effect in the focal zone (9) for the incident electromagnetic field, the electromagnetically opaque zone being made of an absorbing material or a reflecting material for the incident electromagnetic field.

5. Device of claim 4, wherein the at least one aperture focusing element (4) comprises at least one groove formed in the bottoms surface (32) of the at least one dielectric layer (3), said at least one groove being filled with the electromagnetic opaque material in a manner to form at least two alternating electromagnetic transparent and opaque zones.

6. Device of claim 4, wherein the at least on aperture focusing element (4) comprises a dielectric layer which is attached to the bottom surface (32) of the at least one dielectric layer (3), said at least one aperture focusing element (4) comprising at least two grooves formed in said dielectric layer and filled alternatively with a transparent material and an opaque material in a manner to form at least two alternating electromagnetic transparent and opaque zones.

7. Device of claim 2 to 4, wherein the least one aperture focusing element (4) comprises at least one through hole formed in the at least one conductive layer (6), said at least one through hole being filled with an electromagnetically transparent material for the incident electromagnetic field in a manner to form at least two alternating electromagnetic transparent and opaque zones.

8. Device of claim 2 to 4, wherein the at least one aperture focusing element (4) comprises a dielectric layer which is attached to the bottom surface (62) of the at least one conductive layer (62), said at least one aperture focusing element (4) comprising at least two grooves formed in said dielectric layer and filled alternatively with a transparent material and an opaque material in a manner to form at least two alternating electromagnetic transparent and opaque zones.

9. Device of any of claims 1 to 3, wherein the at least one aperture focusing element (4) comprises at least two alternating electromagnetically transparent zones made of two different dielectric transparent materials to generate a focusing effect in the focal zone (9) for the incident electromagnetic field.

10. Device of claim 9, wherein the at least one aperture focusing element (4) comprises at least one groove formed in the bottom surface (32) of the at least one dielectric layer (3), said at least one groove being filled with a dielectric material in a manner to form at least two alternating electromagnetically transparent zones made of two different transparent dielectric materials.

11. Device of claim 9, wherein the at least one aperture focusing element (4) comprises a dielectric layer and is attached to the bottom surface (32) of the at least one dielectric layer (3), said at least one aperture focusing element (4) comprising at least two grooves formed is said dielectric layer and filled alternatively with a first dielectric transparent material and a second dielectric transparent material in a manner to form at least two alternating electromagnetic transparent zones.

12. Device of claim 2, claim 3 and claim 9, wherein the at least one aperture focusing element (4) comprises a dielectric layer and is attached to the bottom surface (62) of the at least one conductive layer (62), said at least one aperture focusing element (4) comprising at least two grooves formed in said dielectric layer and filled alternatively with a first dielectric transparent material and a second dielectric transparent material in a manner to form at least two alternating electromagnetic transparent zones.

13. Device of any of claims 1-3, wherein the at least one aperture focusing element (4) comprises a plurality of phase shifting elements arranged in the XY-plane to produce a phase correcting effect on the electromagnetic field (16) incident on the aperture focusing element (4) to generate a focusing effect in the focal zone (9).

14. Device of any of claims 1-3, wherein the at least one aperture focusing element (4) comprises a plurality of dielectric pillars with sub-wavelength dimensions arranged in the XY-plane to produce a phase correcting effect on the electromagnetic field (16) incident on the aperture focusing element (4) to generate a focusing effect in the focal zone (9).

15. Device of any of claims 1-3, wherein the at least one aperture focusing element (4) comprises a free-form volumetric refractive lens made of a transparent dielectric material with concave profile, such as plano-convex lens, or a concentric zone lens with each zone **characterized by** different value of the effective dielectric permittivity to produce a phase correcting effect on the electromagnetic field (16) incident on the aperture focusing element (4) to generate a focusing effect in the focal zone (9).

16. Device of any of claims 1 - 15 and of claims 2, further comprising at least one spacer dielectric layer (8) positioned on the bottom surface (32) of the at least one dielectric layer (3) or on the bottom surface (62) of the conductive layer (6), the thickness (T₃) of the spacer dielectric layer (8) being sensibly equal to the focal length (F) of the at least one aperture focusing element (4).

17. Device of any of claims 1-16, wherein the at least one sensor (5) comprises an electromagnetic sensor operating at a frequency of the electromagnetic source (2).

18. Device of any of claims 1-16, wherein the at least one sensor (5) comprises an electromagnetic sensor operating at a frequency different from that of the electromagnetic source (2), the device further comprising frequency converter element (18).

19. Device of any of claims 1-16, wherein the at least one sensor (5) comprises a thermal sensor.

20. Device of any of claim 19, further comprising at least one heat converting element placed in the focal zone (9), the at least one thermal sensor being positioned in direct contact with the at least one heat converting element.

21. Device according to any of claims 1-20, comprising a plurality of aperture focusing elements (4) and a plurality of sensors (5), each sensor being placed in a focal zone (9) of at least one an aperture focusing element (4).
